# EUROPEAN PATENT APPLICATION

(11) **EP 4 650 911 A1**
(43) Date of publication of application: **19.11.2025**
(21) Application number: 24222988.8
(22) Date of filing: 23.12.2024
(51) Int. Cl.: G06F 1/18, G06F 1/30, G11C 5/00, H05K 7/14

(54) **STORAGE DEVICE, ELECTRONIC DEVICE INCLUDING THE SAME, AND OPERATING METHOD OF THE ELECTRONIC DEVICE**

(30) Priority: 13.05.2024 KR 20240062510; 11.09.2024 KR 20240123636
(71) Applicant: Samsung Electronics Co., Ltd., Suwon-si, Gyeonggi-do 16677 (KR)
(72) Inventor: SON, Jung Moo, 16677 Suwon-si, Gyeonggi-do (KR); KIM, Bum Jun, 16677 Suwon-si, Gyeonggi-do (KR); BYUN, Jae Beom, 16677 Suwon-si, Gyeonggi-do (KR); LEE, Ki Taek, 16677 Suwon-si, Gyeonggi-do (KR)
(74) Representative: Kuhnen & Wacker Patent- und Rechtsanwaltsbüro PartG mbB

(57) **Abstract**

A storage device includes: a substrate including a first surface which extends in first and second directions intersecting each other; an electronic element disposed on the first surface of the substrate; a connector connected to a host device; a tray on which the substrate is mounted; and a guide frame disposed in the tray to support the substrate and having a slot formed to extend along the first direction to a first length, in which, when a loss of power provided from the host device occurs, the tray moves along the slot by the first length.

## Description

This application claims the benefit of Korean Patent Application No. 10-2024-0062510, filed on May 13, 2024, and Korean Patent Application No. 10-2024-0123636, filed on September 11, 2024, in the Korean Intellectual Property Office, the disclosures of which are incorporated herein in their entirety by reference.

### BACKGROUND

As data consumption increases and the demand for data security increases, increasing the data processing capacity or performance of server devices is becoming an important topic. In addition, as the capacity and performance of functional modules or functional blocks constituting a service device and performing data storage or data processing increase, the power consumed by each module or block to operate also increases.

Accordingly, when a power problem such as power loss occurs in a functional module or functional block during the operation of the server device, measures to protect data from the power loss are required.

### SUMMARY

In general, in some aspects, the present disclosure is directed to a storage device capable of operating stably despite a power loss, an electronic device capable of operating stably despite a power loss, and an operating method of an electronic device capable of operating stably despite a power loss.

According to some implementations, the present disclosure is directed to a storage device that includes a substrate including a first surface which extends in first and second directions intersecting each other; an electronic element disposed on the first surface of the substrate; a connector connected to a host device; a tray on which the substrate is mounted; and a guide frame disposed in the tray to support the substrate and having a slot formed to extend along the first direction to a first length, wherein when a loss of power provided from the host device occurs, the tray moves along the slot by the first length.

According to some implementations, the present disclosure is directed to an electronic device that includes a storage device; and a host device connected to the storage device, wherein the host device includes a power supply unit supplying main power to the storage device, a baseboard management controller (BMC) module providing a data flush command to the storage device when a loss of the main power occurs and a power loss protection (PLP) module providing a detection signal to the BMC module by detecting the loss of the main power and supplying auxiliary power when the loss of the main power occurs, and the storage device includes a substrate, a volatile memory and a nonvolatile memory disposed on the substrate, a connector disposed at an end of the substrate and connected to the host device, a tray on which the substrate is mounted and a guide frame having a slot formed to extend to a first length, wherein when the loss of the main power occurs, the tray moves along the slot by the first length.

According to some implementations, the present disclosure is directed to an electronic device that includes a storage device; a host device including a power supply unit which supplies main power to the storage device; and a latch unit connected to the host device through a switch, wherein the host device includes a BMC module providing a data flush command to the storage device when the latch unit and the host device are separated and a PLP module monitoring the power status of the power supply unit and supplying auxiliary power to the storage device, and the storage device includes a substrate, a volatile memory and a nonvolatile memory disposed on the substrate, a connector disposed at an end of the substrate and connected to the host device, a tray on which the substrate is mounted and a guide frame having a slot formed to extend to a first length, wherein when the latch unit and the host device are separated, the tray moves along the slot by the first length.

According to some implementations, the present disclosure is directed to an operating method of an electronic device that includes a host device, a storage device having a tray pin and a slot formed to correspond to each other, and a latch unit connected to the host device through a switch. The method includes: detecting an off state of the switch using the host device; providing a data flush command to the storage device using the host device; and letting the tray pin be accommodated in the slot and move along the slot by a first length.

### BRIEF DESCRIPTION OF THE DRAWINGS

Example implementations will be more clearly understood from the following detailed description, taken in conjunction with the accompanying drawings.
FIG. 1 is a block diagram of an example of an electronic device according to some implementations.
FIGS. 2 and 3 are perspective views of an example of a storage device according to some implementations.
FIG. 4 is a schematic view of an example of a guide frame of FIG. 3 according to some implementations.
FIG. 5 is an enlarged view of an example of a portion of the guide frame of FIG. 4 according to some implementations.
FIGS. 6 and 7 are plan views of the storage device of FIG. 3 according to some implementations.
FIG. 8 is a side view of the storage device of FIG. 7 according to some implementations.
FIG. 9 is a flowchart illustrating an example of an operating method of an electronic device according to some implementations.
FIGS. 10 through 13 are intermediate diagrams for explaining the operating method of the electronic device according to some implementations.
FIGS. 14 through 19 are block diagrams of examples of electronic devices according to some implementations.
FIG. 20 illustrates an example of a data center to which a storage device is applied according to some implementations.

### DETAILED DESCRIPTION

Hereinafter, example implementations will be described with reference to the accompanying drawings.

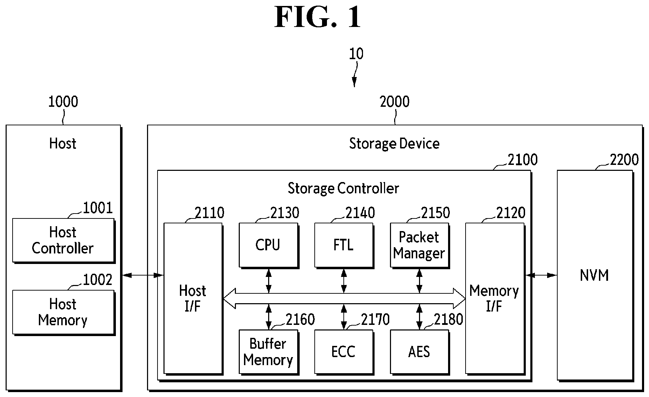

FIG. 1 is a block diagram of an example of an electronic device according to some implementations. In FIG. 1,an electronic device 10 may include a host device 1000 and a storage device 2000. In addition, the storage device 2000 may include a storage controller 2100 and a nonvolatile memory 2200. In addition, in some implementations, the host device 1000 may include a host controller 1001 and a host memory 1002. The host memory 1002 may function as a buffer memory for temporarily storing data to be transmitted to the storage device 2000 or data received from the storage device 2000.

The storage device 2000 may include storage media for storing data according to a request from the host device 1000. For example, the storage device 2000 may include at least one of a solid state drive (SSD), an embedded memory, and a removable external memory. When the storage device 2000 is an SSD, it may be a device that follows a nonvolatile memory express (NVMe) standard. When the storage device 2000 is an embedded memory or an external memory, it may be a device that includes a universal flash storage (UFS) standard or an embedded multi-media card (eMMC) standard. Each of the host device 1000 and the storage device 2000 may generate and transmit a packet according to an adopted standard protocol.

When the nonvolatile memory 2200 of the storage device 2000 includes a flash memory, the flash memory may include a 2D NAND memory array or a 3D (or vertical) NAND (VNAND) memory array. In some implementations, the storage device 2000 may include various other types of nonvolatile memories. For example, the storage device 2000 may include a magnetic random access memory (MRAM), a spin-transfer torque MRAM, a conductive bridging random access memory (CBRAM), a ferroelectric random access memory (FeRAM), a phase-change random access memory (PRAM), a resistive random access memory (RRAM), and various other types of memories.

In some implementations, the host controller 1001 and the host memory 1002 may be implemented as separate semiconductor chips. In some implementations, the host controller 1001 and the host memory 1002 may be integrated into the same semiconductor chip. For example, the host controller 1001 may be any one of a plurality of modules included in an application processor, and the application processor may be implemented as a system-on-chip (SoC). In addition, the host memory 1002 may be an embedded memory included in the application processor or may be a nonvolatile memory or memory module disposed outside the application processor.

The host controller 1001 may manage an operation of storing data (e.g., write data) of a buffer area in the nonvolatile memory 2200 or storing data (e.g., read data) of the nonvolatile memory 2200 in the buffer area.

The storage controller 2100 may include a host interface 2110, a memory interface 2120, and a central processing unit (CPU) 2130. In addition, the storage controller 2100 may further include a flash translation layer (FTL) 2140, a packet manager 2150, a buffer memory 2160, an error correction code (ECC) engine 2170, and an advanced encryption standard (AES) engine 2180.

The storage controller 2100 may further include a working memory into which the FTL 2140 is loaded. Data writing and reading operations on the nonvolatile memory 2200 may be controlled by executing the FTL 2140 using the CPU 2130.

The host interface 2110 may transmit and receive packets to and from the host device 1000. A packet transmitted from the host device 1000 to the host interface 2110 may include a command or data to be written to the nonvolatile memory 2200, and a packet transmitted from the host interface 2110 to the host device 1000 may include a response to a command or data read from the nonvolatile memory 2200.

The memory interface 2120 may transmit data to be written to the nonvolatile memory 2200 to the nonvolatile memory 2200 or may receive data read from the nonvolatile memory 2200. The memory interface 2120 may be implemented to comply with a standard protocol such as Toggle or ONFI.

The FTL 2140 may perform various functions such as address mapping, wear-leveling, and garbage collection. The address mapping operation is an operation of converting a logical address received from a host into a physical address used to actually store data in the nonvolatile memory 2200. The wear-leveling is a technology for preventing excessive deterioration of a specific block by ensuring that blocks in the nonvolatile memory 2200 are evenly used. For example, the wear-leveling may be implemented through firmware technology that balances erase counts of physical blocks. The garbage collection is a technology for securing available capacity in the nonvolatile memory 2200 by copying valid data of a block to a new block and then erasing the existing block.

The packet manager 2150 may generate a packet according to the protocol of an interface agreed upon with the host device 1000 or may parse various information from a packet received from the host device 1000. In addition, the buffer memory 2160 may temporarily store data to be written to the nonvolatile memory 2200 or data to be read from the nonvolatile memory 2200. The buffer memory 2160 may be a component included in the storage controller 2100, but may also be disposed outside the storage controller 2100.

The ECC engine 2170 may perform an error detection and correction function on data read from the nonvolatile memory 2200. More specifically, the ECC engine 2170 may generate parity bits for write data to be written to the nonvolatile memory 2200, and the generated parity bits may be stored in the nonvolatile memory 2200 together with the write data. When data is read from the nonvolatile memory 2200, the ECC engine 2170 may correct an error in the read data using the read data and parity bits read from the nonvolatile memory 2200 and may output the error-corrected read data.

The AES engine 2180 may perform at least one of an encryption operation and a decryption operation on data input to the storage controller 2100 by using a symmetric-key algorithm.

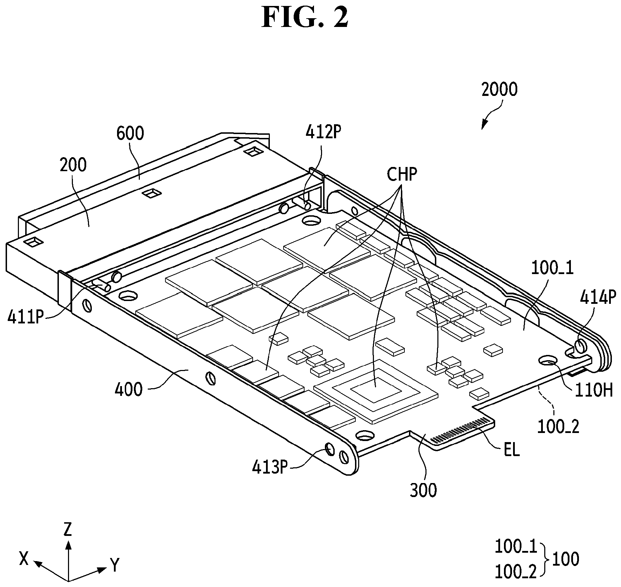

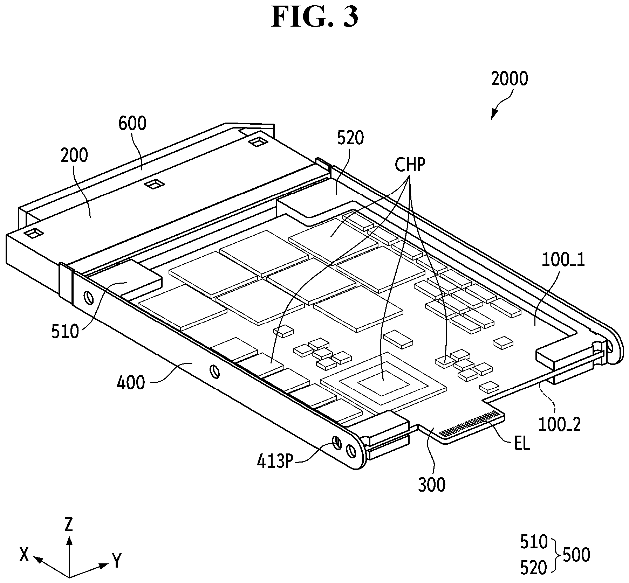

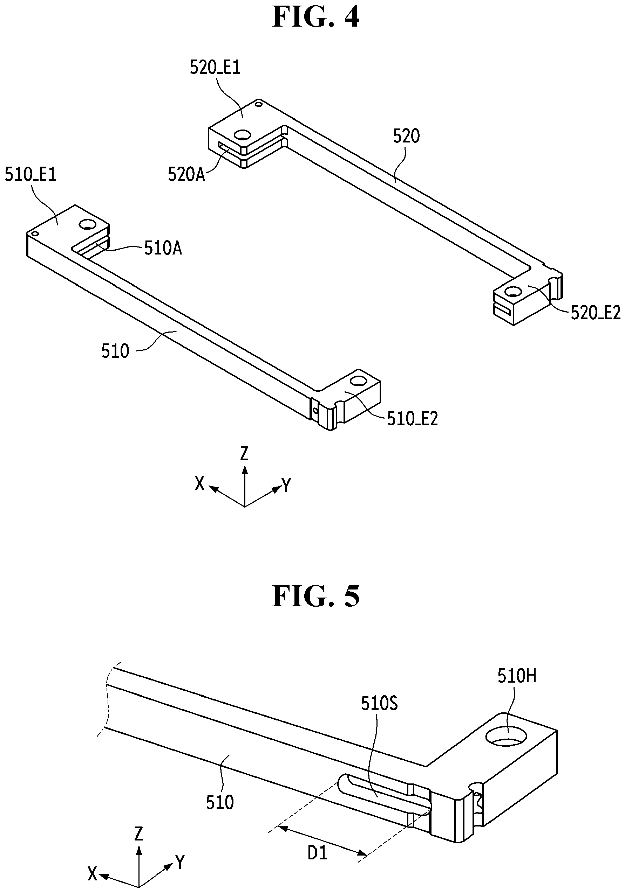

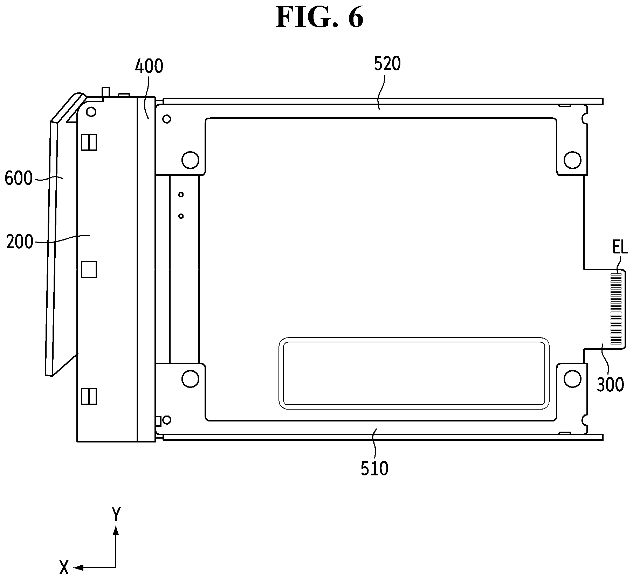

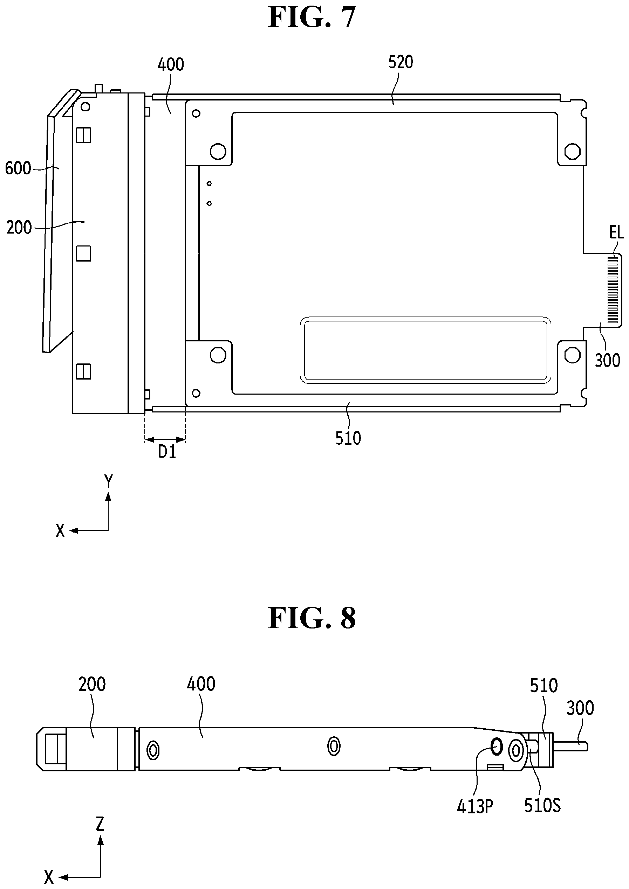

FIGS. 2 and 3 are perspective views of an example of a storage device 2000 according to some implementations. FIG. 4 is a schematic view of an example of a guide frame 500 of FIG. 3 according to some implementations. FIG. 5 is an enlarged view of an example of a portion of the guide frame 500 of FIG. 4 according to some implementations. FIGS. 6 and 7 are plan views of the storage device 2000 of FIG. 3 according to some implementations. FIG. 8 is a side view of the storage device 2000 of FIG. 7 according to some implementations.

In FIGS. 2 and 3, the storage device 2000 may include a substrate 100, a lower case 200, electronic elements CHP, a connector 300, a tray 400, the guide frame 500, and a latch unit 600. The storage device 2000 may be substantially shaped like a rectangular parallelepiped. The appearance of the storage device 2000 may follow a standardized or arbitrary form factor. The dimensions of the storage device 2000 shaped like a rectangular parallelepiped may also be changed according to various criteria.

The substrate 100 may include one or more insulating layers and wiring layers. The substrate 100 may include, for example, a printed circuit board. The substrate 100 may include a first surface 100_1 and a second surface 100_2 facing each other. The first surface 100_1 and the second surface 100_2 may extend in first and second directions X and Y intersecting each other. The first surface 100_1 and the second surface 100_2 may face each other in a third direction Z perpendicularly intersecting each of the first and second directions X and Y. The first surface 100_1 and the second surface 100_2 of the substrate 100 may refer to an upper surface and a lower surface, respectively.

The substrate 100 may include one or more fastening holes 110H. The fastening holes 110H may penetrate the substrate 100 in the third direction Z. Each of the fastening holes 110H may provide a space into which a fastening member such as a screw, a piece or a bolt is inserted, but the present disclosure is not limited thereto.

The fastening holes 110H may be disposed at corners of the substrate 100. However, the present disclosure is not limited thereto, and the fastening holes 110H may also be omitted from some corners or may be further installed in an area other than the corners (e.g., a central portion, an area adjacent to a side).

The lower case 200 may be disposed under the substrate 100 and may cover a lower portion of the substrate 100. The lower case 200 may include a space in which the substrate 100 and the electronic elements CHP can be accommodated.

For example, the lower case 200 may include a material with high thermal conductivity so as to be suitable for dissipating heat generated from the electronic elements CHP to the outside, but the present disclosure is not limited thereto.

In some implementations, the storage device 2000 may not include an upper case which covers an upper portion of the substrate 100.

The electronic elements CHP may be disposed on the first surface 100_1 and/or the second surface 100_2 of the substrate 100. The electronic elements CHP may be manufactured in the form of chips separate from the substrate 100 and then mounted on the substrate 100.

The electronic elements CHP may include a semiconductor element. For example, the semiconductor element may include a nonvolatile memory, such as a NAND flash memory, a volatile memory, such as a dynamic random access memory (DRAM), and a memory controller that controls the memories. In some implementations, the storage controller 2100, the host interface 2110, the memory interface 2120, the CPU 2130, and the buffer memory 2160, as illustrated in FIG. 1, may be manufactured in the form of the electronic elements CHP and mounted on the substrate 100. In some implementations, the electronic elements CHP may further include a capacitor element. Each of the electronic elements CHP may be connected to wiring of the substrate 100 to perform an electrical operation. The electronic elements CHP may be spaced apart from each other. A horizontal gap may be defined in each space between the electronic elements CHP. The horizontal gap may be filled with air or the like.

The connector 300 may be disposed at an end of the substrate 100. The connector 300 may be connected to the substrate 100. The connector 300 may be provided as a separate member from the substrate 100 and attached to the substrate 100. However, in some implementations, the connector 300 may also be integrated with the substrate 100. When the connector 300 is integrated with the substrate 100, it may be provided in a protruding area of the substrate 100 where a portion of the substrate 100 protrudes outward.

The connector 300 may include a plurality of connection terminals EL. The connection terminals EL may be spaced apart from each other along the second direction Y. Each connection terminal EL of the connector 300 may be connected to a corresponding connection portion of the host device 1000 (see FIG. 1).

Each connection terminal EL of the connector 300 may be connected to the wiring of the substrate 100. When the connector 300 is integrated with the substrate 100, the connection terminals EL of the connector 300 may be formed on the same layer using the same material as the wiring of the substrate 100. The connection terminals EL may be at least partially exposed to the outside without being covered by an insulating layer.

The substrate 100 may be mounted on the tray 400. The tray 400 may include first and second pins 411P and 412P protruding in the first direction X and third and fourth pins 413P and 414P protruding in the second direction Y.

The first and second pins 411P and 412P may extend in the first direction X and may be spaced apart from each other in the second direction Y. The third and fourth pins 413P and 414P may extend in the second direction Y and may be spaced apart from each other in the second direction Y.

The first and second pins 411P and 412P and the third and fourth pins 413P and 414P may be coupled to the guide frame 500 described below.

The guide frame 500 may be disposed in the tray 400 and may support the substrate 100. At least one slot 510S and at least one frame hole 510H may be formed in the guide frame 500. The frame hole 510H may correspond to each of the fastening holes 110H and provide a space into which a fastening member, such as a screw, a piece, or a bolt, is inserted, but the present disclosure is not limited thereto.

The guide frame 500 may include first and second members 510 and 520 which are parallel in the first direction X and face each other in the second direction Y. In a state where the substrate 100 is supported, the first and second members 510 and 520 may be spaced apart from each other to face each other in the second direction Y.

One end 510_E1 and the other end 510_E2 of the first member 510 may protrude in the second direction Y toward the inside of the substrate 100. One end 520_E1 and the other end 520_E2 of the second member 520 may protrude in the second direction Y toward the inside of the substrate 100.

The first and second members 510 and 520 may support the substrate 100. One side of the substrate 100 may be supported by the first member 510, and the other side of the substrate 100 facing the above side may be supported by the second member 520. A first groove 510A may be formed in the first member 510, and a second groove 520A may be formed in the second member 520. The one side and the other side of the substrate 100 may be inserted into the grooves 510A and 520A of the first and second members 510 and 520 and thus may be stably supported.

The one end 510_E1 and the other end 510_E2 of the first member 510 and the one end 520_E1 and the other end 520_E2 of the second member 520 may cover the corners of the substrate 100, respectively. However, in some implementations, the first and second members 510 and 520 may not completely cover the substrate 100. For example, the first and second members 510 and 520 may expose the substrate 100 on which the electronic elements CHP and the connector 300 are formed.

The slot 510S may be formed in at least one of the first and second members 510 and 520. The slot 510S may extend along the first direction X to a first length D1.

For example, FIG. 5 illustrates the slot 510S formed in a portion of the first member 510. The slot 510S may be shaped like a hole that completely penetrates the first member 510. However, in some implementations, the slot 510S may also be shaped like a groove that partially, not completely, penetrates the first member 510. The above length of the slot 510S is only an example and the present disclosure is not limited to that illustrated in the drawing. For example, as will be described later, the length of the slot 510S may be appropriately changed within the first member 510 in order to secure a data flush time. For example, the length of the slot 510S may be equal to or less than a length of the first member 510 in the first direction X.

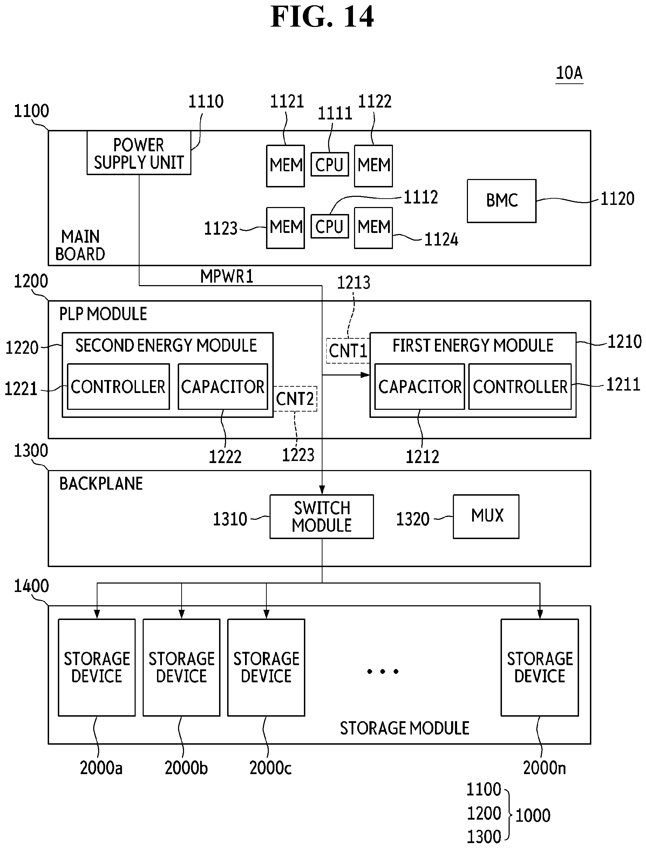

FIG. 6 illustrates the storage device 2000 before a loss of first main power MPWR1 (see FIG. 14) occurs, for example, before the tray 400 moves. FIGS. 7 and 8 illustrate the storage device 2000 when the tray 400 moves due to a loss of the first main power MPWR1 (see FIG. 14).

In FIGS. 7 and 8, when a loss of the first main power MPWR1 (see FIG. 14) occurs, the tray 400 may move along the slot 510S in the first direction X by the first length D1. The third pin 413P of the tray 400 may be accommodated in the slot 510S so that the tray 400 can move. A distance D1 that the tray 400 moves may be equal to the length D1 of the slot 510S.

The latch unit 600 may be connected to a host device 1000 (see FIG. 14) through a switch. When the latch unit 600 and the host device 1000 (see FIG. 14) are connected, a latch-closed state may be entered. When the latch unit 600 and the host device 1000 (see FIG. 14) are separated, a latch-open state may be entered. The latch-open state may refer to a switch-off state.

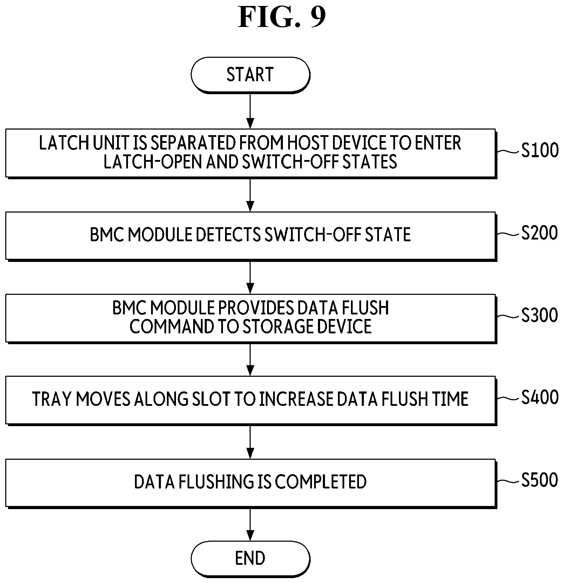

For example, the latch unit 600 may be detachably provided in the lower case 200. The latch unit 600 will be described in more detail using FIGS. 9 through 13.

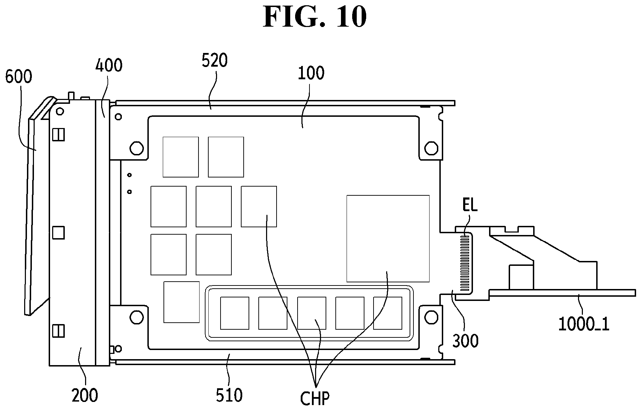

FIG. 9 is a flowchart illustrating an example of an operating method of an electronic device according to some implementations. FIGS. 10 through 13 are intermediate diagrams for explaining the operating method of the electronic device according to some implementations.

FIG. 10 illustrates a case where the latch unit 600 and the host device 1000 (see FIG. 14) are connected to enter a latch-closed state. In this case, the latch unit 600 may be electrically connected to a pad (not illustrated) disposed at one end of the host device 1000 (see FIG. 14) through the switch (not illustrated). The connector 300 may be connected to the other end 1000_1 of the host device 1000 (see FIG. 14).

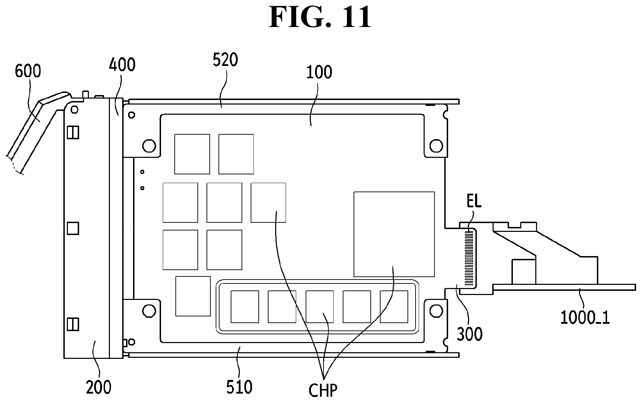

FIG. 11 illustrates a case where the latch unit 600 and the host device 1000 (see FIG. 14) are separated to enter a latch-open state. In this case, the latch unit 600 may be electrically separated from the pad disposed at the one end of the host device 1000 (see FIG. 14) through the switch.

In FIGS. 9 and 11, for example, a problem may occur in some of the components of the host device 1000 (see FIG. 14), resulting in a sudden loss of power supplied to the storage device 2000. In this case, the latch unit 600 and the host device 1000 (see FIG. 14) may be separated to enter a latch-open state and a switch-off state (operation S100).

Next, the host device 1000 (see FIG. 14) may detect the switch-off state (operation S200). The host device 1000 (see FIG. 14) may detect the switch-off state through a wire electrically connected to the connector 300. More specifically, a baseboard management controller (BMC) module 1120 (see FIG. 14) to be described later may detect the switch-off state through the wire.

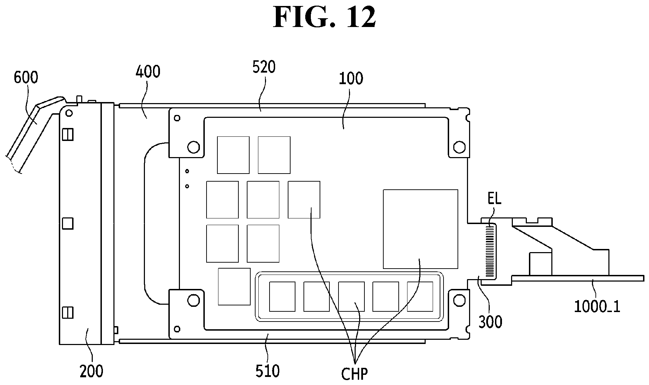

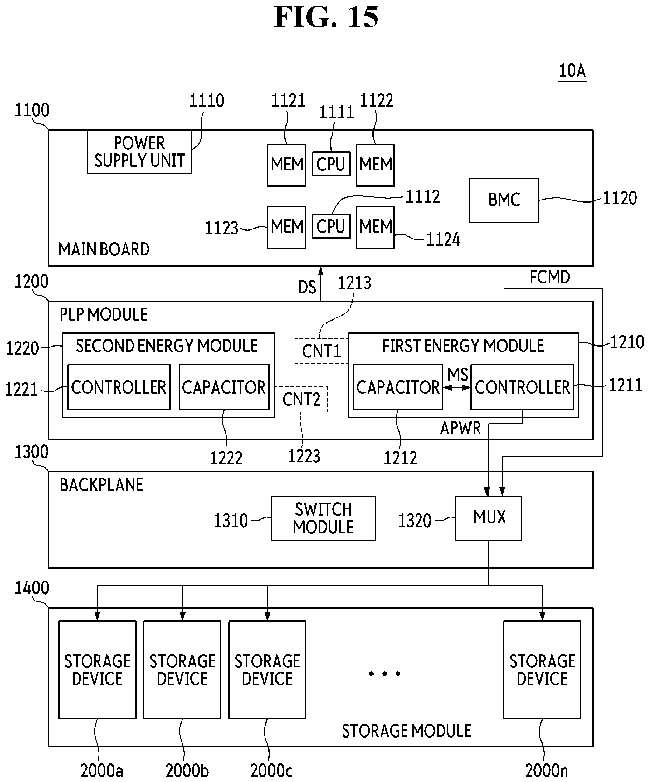

Next, in FIGS. 9 and 12, the host device 1000 (see FIG. 14) may provide a data flush command FCMD (see FIG. 15) to the storage device 2000 (see FIG. 3) (operation S300). Accordingly, the tray 400 may move along the slot 510S (see FIG. 8) by the first length D1 (see FIG. 7). More specifically, a tray pin 413P (see FIG. 8) may move along the slot 510S (see FIG. 8) by the first length D1 (see FIG. 7).

The tray 400 may be configured to transmit an electrical signal, such as the data flush command FCMD (see FIG. 15), to the electronic components CHP of the storage device 2000.

Accordingly, a data flush time may be increased by a time corresponding to the first length D1 (see FIG. 7) (operation S400).

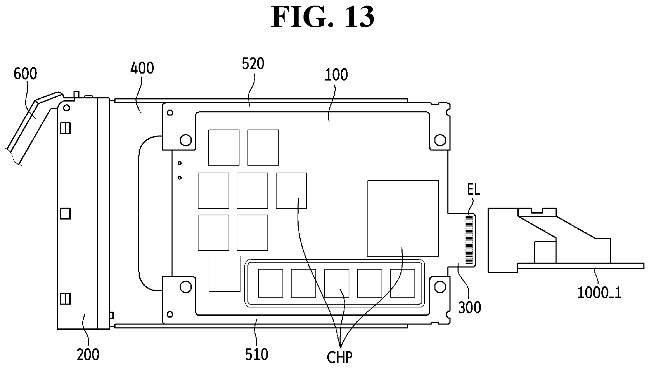

Next, in FIGS. 9 and 13, after the tray 400 moves along the slot 510S (see FIG. 8) by the first length D1 (see FIG. 7), data flushing may be completed (operation S500). More specifically, after the tray pin 413P (see FIG. 8) moves along the slot 510S (see FIG. 8) by the first length D1 (see FIG. 7), data flushing may be completed. The connector 300 may be separated from the other end 1000_1 of the host device 1000 (see FIG. 14).

As the tray 400 moves along the slot 510S (see FIG. 8) as described above, the data flush time may be delayed by a time corresponding to the distance moved. For example, the data flush time may be, but is not limited to, about 100 ms or more. According to some implementations, data loss that may occur at the moment when the latch unit 600 is separated from the host device 1000 (see FIG. 14) can be minimized by delaying the data flush time through the slot 510S formed in the storage device 2000.

FIGS. 14 and 15 are block diagrams of examples of an electronic device 10A according to some implementations. For reference, FIG. 14 illustrates a case where main power is supplied, and FIG. 15 illustrates a case where auxiliary power is supplied due to a loss of the main power.

In FIGS. 14 and 15, the electronic device 10A may include a host device 1000 and a storage module (circuit) 1400. The host device 1000 may include a main board 1100, a power loss protection (PLP) module (circuit) 1200, and a backplane 1300.

The main board 1100 may include a power supply 1110, a first CPU 1111, a second CPU 1112, memories 1121 through 1124, and a BMC module (circuit) 1120. The power supply 1110, the first CPU 1111, the second CPU 1112, the memories 1121 through 1124, and the BMC module 1120 may be mounted on the main board 1100.

In FIG. 14, the power supply 1110 may receive power from an external device and supply first main power MPWR1 to the storage module 1400 through the main board 1100. The first CPU 1111, the second CPU 1112, the memories 1121 through 1124, and the BMC module 1120 mounted on the main board 1100 may operate based on the first main power MPWR1.

A first memory 1121 and a second memory 1122 may be electrically connected to the first CPU 1111. A third memory 1123 and a fourth memory 1124 may be electrically connected to the second CPU 1112.

The first CPU 1111 and the second CPU 1112 may be configured to execute an operating system and various applications. For example, the first and second CPUs 1111 and 1112 may include various accelerators (or acceleration processors) configured to perform unique operations, such as a graphics processing unit (GPU), a digital signal processor (DSP), an image signal processor (ISP) and a neural processing unit (NPU), but the present disclosure is not limited thereto.

The first CPU 1111 may use the first memory 1121 and the second memory 1122 as working memories. The second CPU 1112 may use the third memory 1123 and the fourth memory 1124 as working memories. For example, the memories 1121 through 1124 may be DRAMs and may have a form factor of a dual in-line memory module (DIMM). However, the present disclosure is not limited thereto, and the memories 1121 through 1124 may also include nonvolatile memories such as flash memories, PRAMs, RRAMs, MRAMs, etc.

The first CPU 1111 and the second CPU 1112 may control components disposed on the main board 1100. For example, the first CPU 1111 and the second CPU 1112 may control components disposed on the main board 1100 based on peripheral component interconnection express (PCIe), but the present disclosure is not limited thereto.

The BMC module 1120 may control the supply of the first main power MPWR1 received from the power supply 1110 to the first CPU 1111, the second CPU 1112, and the memories 1121 through 1124.

The PLP module 1200 may include first and second energy modules (circuits) 1210 and 1220. The first energy module 1210 may include a first controller 1211 and a first capacitor 1212. The second energy module 1220 may include a second controller 1221 and a second capacitor 1222. Each of the first and second controllers 1211 and 1221 may monitor the power status of the power supply unit 1110.

As will be described later, when a loss of the first main power MPWR1 occurs, the first capacitor 1212 and the first controller 1211 may supply first auxiliary power to the storage module 1400, and the second capacitor 1222 and the second controller 1221 may supply second auxiliary power to the storage module 1400.

The power supply unit 1110 may charge the first and second capacitors 1212 and 1222 by supplying energy to the first and second capacitors 1212 and 1222. For example, each of the first and second capacitors 1212 and 1222 may be, but is not limited to, an aluminum (Al) capacitor.

For example, the first and second energy modules 1210 and 1220 may be disposed on a printed circuit board. The first energy module 1210 may be mounted on the printed circuit board through a first PLP module connector (CNT1) 1213. The second energy module 1220 may be mounted on the printed circuit board through a second PLP module connector (CNT2) 1223.

Although two PLP modules are illustrated in FIGS. 14 and 15, the number of PLP modules is not limited to that illustrated in the drawings.

The backplane 1300 may transmit the first main power MPWR1 supplied from the power supply 1110 to the storage module 1400.

The backplane 1300 may be disposed between the host device 1000 and the storage module 1400 to connect the host device 1000 and the storage module 1400. The backplane 1300 may be configured to allow the host device 1000 and the storage module 1400 to exchange data through various communication protocols.

The backplane 1300 may include a switch module 1310 and a multiplexer (MUX) 1320.

For example, the switch module 1310 may selectively supply power to at least one of storage devices 2000a through 2000n of the storage module 1400. The switch module 1310 may supply power to a storage device 2000a through 2000n that requires power supply according to a switching operation.

The backplane 1300 may include storage device connectors corresponding to a plurality of storage devices 2000a through 2000n and connected to the storage devices 2000a through 2000n, respectively.

The storage module 1400 may refer to a set of storage devices 2000a through 2000n. Each of the storage devices 2000a through 2000n may be a component corresponding to the storage device 2000 of FIG. 3. Each of the storage devices 2000a through 2000n may include a nonvolatile memory, a volatile memory, and a memory controller. Here, the nonvolatile memory, the volatile memory, and the memory controller may be components included in the electronic elements CHP of FIG. 3.

In FIG. 15, the PLP module 1200 may monitor the power status of the power supply 1110. The PLP module 1200 may detect a loss of the first main power MPWR1 (see FIG. 14) and output a detection signal DS. For example, the first controller 1211 may monitor the power status of the power supply 1110, detect a power-off state of the first main power MPWR1 (see FIG. 14), and output the detection signal DS.

The PLP module 1200 may provide the output detection signal DS to the BMC module 1120. For example, the first controller 1211 may provide the output detection signal DS to the BMC module 1120.

The first controller 1211 may monitor the power status of the first capacitor 1212 and control the charging and/or discharging of the first capacitor 1212 so that first auxiliary power APWR is supplied to the storage devices 2000a through 2000n. The first controller 1211 and the first capacitor 1212 may transmit and receive a first monitoring signal MS.

The second controller 1221 may monitor the power status of the second capacitor 1222 and control the charging and/or discharging of the second capacitor 1222 so that second auxiliary power is supplied to the storage devices 2000a through 2000n. The second controller 1221 and the second capacitor 1222 may transmit and receive a second monitoring signal (not illustrated).

The exemplary description of the operation of the first controller 1211 and the first capacitor 1212 may be similarly applied to the operation of the second controller 1221 and the second capacitor 1222.

When a loss of the first main power MPWR1 (see FIG. 14) occurs, the BMC module 1120 may provide a data flush command FCMD to the storage module 1400 through the MUX 1320. For example, the BMC module 1120 may receive the detection signal DS output from the first controller 1211 and provide the data flush command FCMD to the storage module 1400.

When a loss of the first main power MPWR1 (see FIG. 14) occurs, the backplane 1300 may transmit the first and second auxiliary power described above to the storage devices 2000a through 2000n through the MUX 1320.

The switch module 1310 may supply energy to the storage module 1400 by using any one of the first and second capacitors 1212 and 1222. For example, if any one of the first and second capacitors 1212 and 1222 cannot operate normally due to a problem, the switch module 1310 may supply energy to the storage module 1400 from a normal capacitor according to a switching operation.

The BMC module 1120 may transmit and receive data to and from the storage devices 2000a through 2000n based on out-of-band communication. The BMC module 1120 and the storage devices 2000a through 2000n may be configured to support the out-of-band communication.

Through this process, even if a loss of main power occurs, auxiliary power can be supplied to the storage module 1400 using the energy of a charged capacitor. When a loss of the main power occurs, the BMC module 1120 may maintain data of a volatile memory or flush the data to a nonvolatile memory.

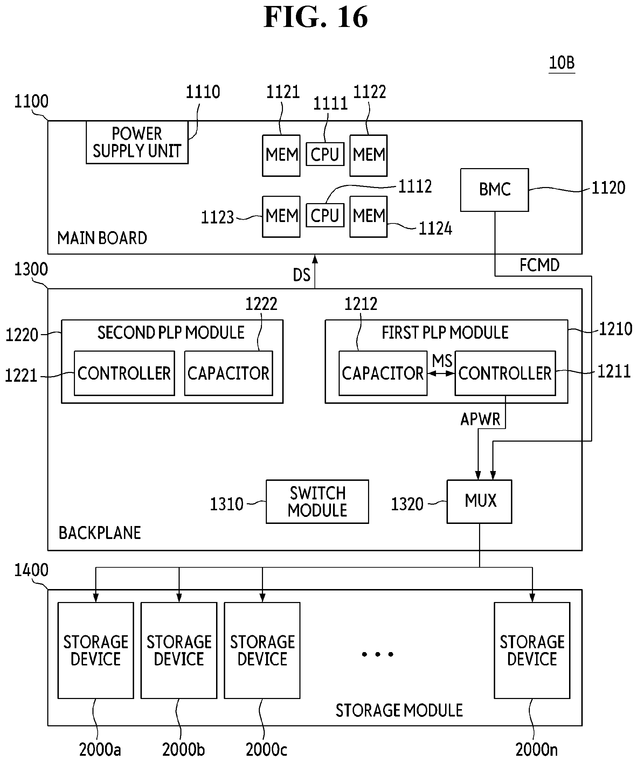

FIG. 16 is a block diagram of an example of an electronic device 10B according to some implementations. For ease of description, the following description will focus on differences from those described using FIGS. 1 through 15.

In FIG. 16, in the electronic device 10B, a backplane 1300 may include first and second PLP modules 1210 and 1220.

The backplane 130 may include the first and second PLP modules 1210 and 1220 which monitor the power status of a power supply 1110 and output a detection signal DS.

In this case, the first and second PLP modules 1210 and 1220 may not be provided as modules separate from the backplane 1300, but may be included in the backplane 1300.

Although two PLP modules are illustrated in FIG. 16, the number of PLP modules is not limited to that illustrated in the drawing.

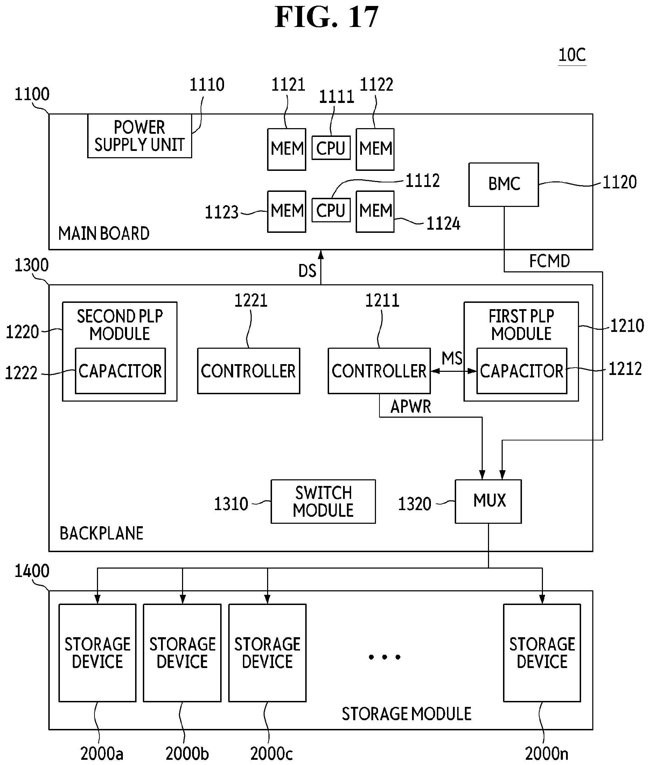

FIG. 17 is a block diagram of an example of an electronic device 10C according to some implementations. For ease of description, the following description will focus on differences from those described using FIGS. 1 through 16.

In FIG. 17, in the electronic device 10C, a controller of a PLP module may be disposed outside the PLP module.

A first PLP module 1210 may include a first capacitor 1212, and a first controller 1211 may be disposed outside the first PLP module 1210. The first controller 1211 may be directly mounted on a backplane 1300.

A second PLP module 1220 may include a second capacitor 1222, and a second controller 1221 may be disposed outside the second PLP module 1220. The second controller 1221 may be directly mounted on the backplane 1300.

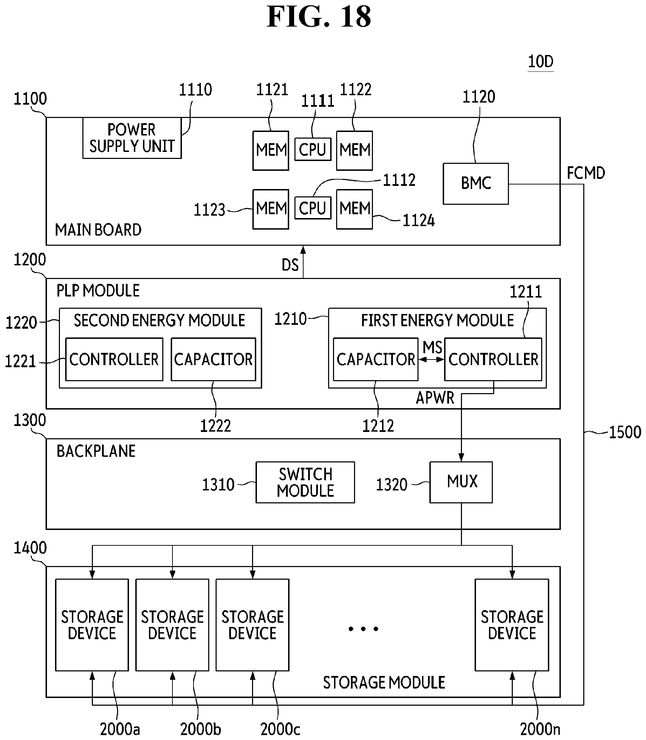

FIG. 18 is a block diagram of an example of an electronic device 10D according to some implementations. For ease of description, the following description will focus on differences from those described using FIGS. 1 through 17.

In FIG. 18, in the electronic device 10D, a BMC module 1120 and storage devices 2000a through 2000n may be directly connected through a signal line 1500 without via a backplane 1300.

The BMC module 1120 may provide a data flush command FCMD to the storage devices 2000a through 2000n through the signal line 1500 directly connected to the storage devices 2000a through 2000n.

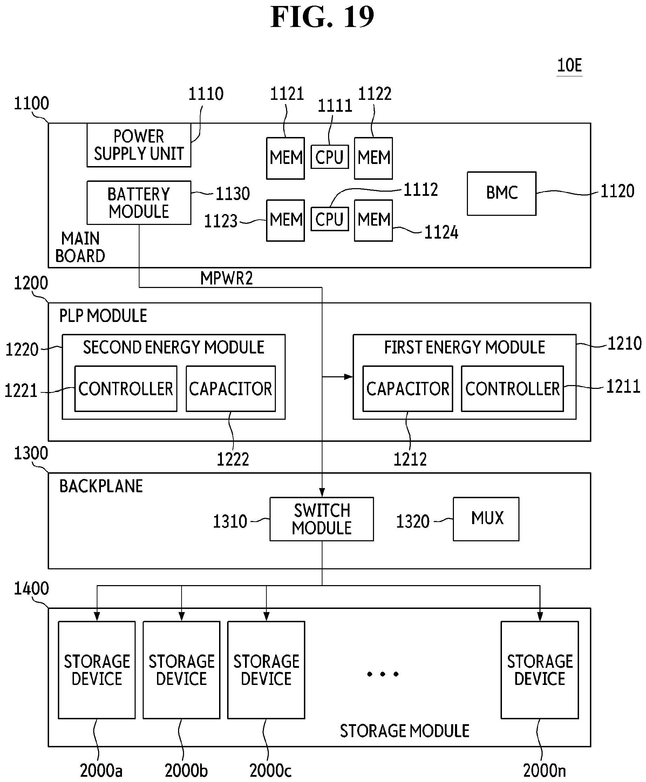

FIG. 19 is a block diagram of an example of an electronic device 10E according to some implementations. For ease of description, the following description will focus on differences from those described using FIGS. 1 through 18.

In FIG. 19, in the electronic device 10E, a host device 1000 may further include a battery module (circuit) 1130 which supplies second main power MPWR2 to storage devices 2000a through 2000n. The battery module 1130 may be mounted on a main board 1100. The battery module 1130 may be provided as a separate component from a power supply 1110. For example, the battery module 1130 may be configured to supply the second main power MPWR2 when first main power MPWR1 is not properly supplied from the power supply 1110.

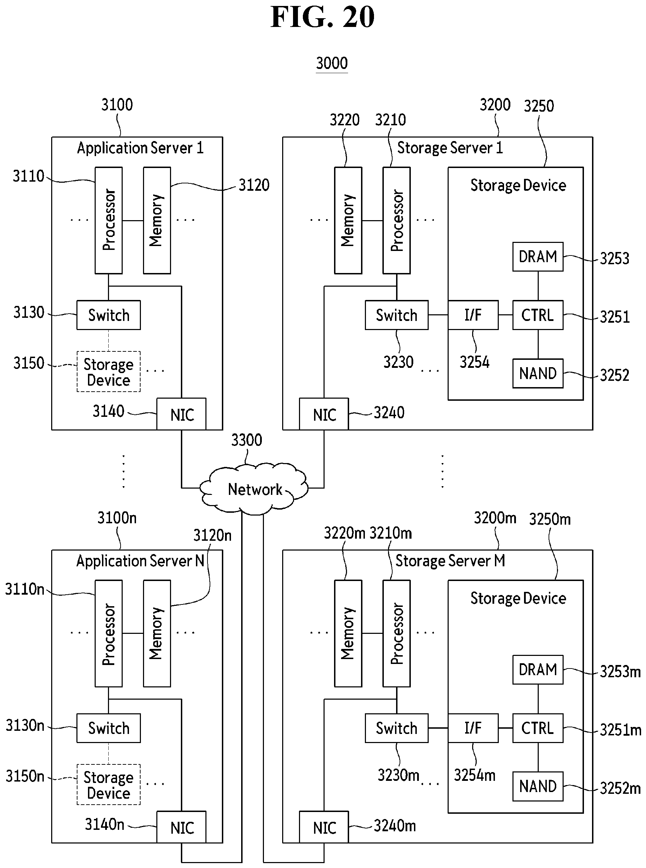

FIG. 20 illustrates a data center 3000 to which a storage device is applied according to some implementations. In FIG. 20, the data center 3000 is a facility that collects various data and provides services and may also be referred to as a data storage center. The data center 3000 may be a system for operating a search engine and a database and may be a computing system used in a company such as a bank or a government agency. The data center 3000 may include application servers 3100 through 3100n and storage servers 3200 through 3200m. The number of application servers 3100 through 3100n and the number of storage servers 3200 through 3200m may be selected variously according to embodiments. The number of application servers 3100 through 3100n and the number of storage servers 3200 through 3200m may be different from each other.

An application server 3100 or a storage server 3200 may include at least one of a processor 3110 or 3210 and a memory 3120 or 3220. For example, in the storage server 3200, the processor 3210 may control the overall operation of the storage server 3200 and may access the memory 3220 to execute commands and/or data loaded into the memory 3220. The memory 3220 may be a double data rate synchronous DRAM (DDR SDRAM), a high bandwidth memory (HBM), a hybrid memory cube (HMC), a dual in-line memory module (DIMM), an Optane DIMM, or a nonvolatile DIMM (NVDIMM). The number of processors 3210 and the number of memories 3220 included in the storage server 3200 may be selected variously according to some implementations.

In some implementations, the processor 3210 and the memory 3220 may provide a processor-memory pair. In some implementations, the number of processors 3210 and the number of memories 3220 may be different from each other. The processor 3210 may include a single-core processor or a multi-core processor. The above description of the storage server 3200 may be similarly applied to the application server 3100. In some implementations, the application server 3100 may not include a storage device 3150. The storage server 3200 may include at least one storage device 3250. The number of storage devices 3250 included in the storage server 3200 may be selected variously according to embodiments.

The storage assembly described above may be mounted on or detached from the storage server 3200, which is a host, in the form of one storage device 3250.

The application servers 3100 through 3100n and the storage servers 3200 through 3200m may communicate with each other through a network 3300. The network 3300 may be implemented using Fibre Channel (FC) or Ethernet. Here, the FC may be a medium used for relatively high-speed data transmission and may use an optical switch that provides high performance/high availability. The storage servers 3200 through 3200m may be provided as file storage, block storage, or object storage according to an access method of the network 3300.

In some implementations, the network 3300 may be a storage dedicated network, such as a storage area network (SAN). For example, the SAN may be an FC-SAN using an FC network and implemented according to an FC protocol (FCP). For another example, the SAN may be an IP-SAN using a TCP/IP network and implemented according to an SCSI over TCP/IP or Internet SCSI (iSCSI) protocol. In some implementations, the network 3300 may be a general network such as a TCP/IP network. For example, the network 3300 may be implemented according to a protocol, such as FC over Ethernet (FCoE), network attached storage (NAS), or NVMe over Fabrics (NVMe-oF).

The following description will focus on the application server 3100 and the storage server 3200. The description of the application server 3100 may also be applied to other application servers 3100n, and the description of the storage server 3200 may also be applied to other storage servers 3200m.

The application server 3100 may store data, which is requested to be stored by a user or a client, in one of the storage servers 3200 through 3200m through the network 3300. In addition, the application server 3100 may obtain data, which is requested to be read by a user or a client, from one of the storage servers 3200 through 3200m through the network 3300. For example, the application server 3100 may be implemented as a web server or a database management system (DBMS).

The application server 3100 may access a memory 3120n or a storage device 3150n included in another application server 3100n through the network 3300 or may access memories 3220 through 3220m or storage devices 3250 through 3250m included in the storage servers 3200 through 3200m through the network 3300. Accordingly, the application server 3100 can perform various operations on data stored in the application servers 3100 through 3100n and/or the storage servers 3200 through 3200m. For example, the application server 3100 may execute a command for transferring or copying data between the application servers 3100 through 3100n and/or the storage servers 3200 through 3200m. In this case, the data may be transferred from the storage devices 3250 through 3250m of the storage servers 3200 through 3200m to the memories 3120 through 3120n of the application servers 3100 through 3100n via the memories 3220 through 3220m of the storage servers 3200 through 3200m or directly. The data transferred through the network 3300 may be data encrypted for security or privacy.

For example, in the storage server 3200, an interface 3254 may provide a physical connection between the processor 3210 and a controller 3251 and a physical connection between an NIC 3240 and the controller 3251. For example, the interface 3254 may be implemented as a direct attached storage (DAS) interface that connects the storage device 3250 directly to a dedicated cable. In addition, for example, the interface 3254 may be implemented as various interfaces, such as advanced technology attachment (ATA), serial-ATA (SATA), external SATA (e-SATA), small computer small interface (SCSI), serial attached SCSI (SAS), peripheral component interconnection (PCI), PCI express (PCIe), NVM express (NVMe), IEEE 1394, universal serial bus (USB), secure digital (SD) card, multi-media card (MMC), embedded MMC (eMMC), universal flash storage (UFS), embedded UFS (eUFS), and compact flash (CF) card interfaces.

The storage server 3200 may further include a switch 3230 and the NIC 3240. The switch 3230 may selectively connect the processor 3210 and the storage device 3250 or selectively connect the NIC 3240 and the storage device 3250 under the control of the processor 3210.

In some implementations, the NIC 3240 may include a network interface card, a network adapter, etc. The NIC 3240 may be connected to the network 3300 by a wired interface, a wireless interface, a Bluetooth interface, an optical interface, or the like. The NIC 3240 may include an internal memory, a DSP, a host bus interface, etc. and may be connected to the processor 3210 and/or the switch 3230 through the host bus interface. The host bus interface may be implemented as one of the above examples of the interface 3254. In some implementations, the NIC 3240 may be integrated with at least one of the processor 3210, the switch 3230, and the storage device 3250.

In the storage servers 3200 through 3200m or the application servers 3100 through 3100n, processors may program or read data by sending a command to the storage devices 3150 through 3150n or 3250 through 3250m or the memories 3120 through 3120n or 3220 through 3220m. Here, the data may be data error-corrected through an ECC engine. The data may be data processed by data bus inversion (DBI) or data masking (DM) and may include cyclic redundancy code (CRC) information. The data may be data encrypted for security or privacy.

The storage devices 3150 through 3150m or 3250 through 3250m may transmit a control signal and a command/address signal to NAND flash memory devices 3252 through 3252m in response to a read command received from the processors. Accordingly, data may be read from the NAND flash memory devices 3252 through 3252m. In this case, a read enable (RE) signal may be input as a data output control signal and may serve to output data to a DQ bus. A data strobe (DQS) may be generated using the RE signal. The command and the address signal may be latched into a page buffer according to a rising edge or falling edge of a write enable (WE) signal.

The controller 3251 may control the overall operation of the storage device 3250. In some implementations, the controller 3251 may include a static random access memory (SRAM). The controller 3251 may write data to the NAND flash memory device 3252 in response to a write command or may read data from the NAND flash memory device 3252 in response to a read command. For example, the write command and/or the read command may be provided from the processor 3210 in the storage server 3200, a processor 3210m in another storage server 3200m, or a processor 3110 or 3110n in an application server 3100 or 3100n. A DRAM 3253 may temporarily store (buffer) data to be written to the NAND flash memory device 3252 or data read from the NAND flash memory device 3252. In addition, the DRAM 3253 may store metadata. Here, the metadata is user data or data generated by the controller 3251 to manage the NAND flash memory device 3252. The storage device 3250 may include a secure element (SE) for security or privacy.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A storage device comprising:
a substrate comprising a first surface that extends in a first direction and a second direction that intersect each other;
an electronic element disposed on the first surface of the substrate;
a connector connected to a host device;
a tray on which the substrate is mounted; and
a guide frame disposed in the tray, the guide frame being configured to support the substrate and having a slot extending along the first direction to a first length,
wherein, when a loss of power provided from the host device occurs, the tray is configured to move along the slot by the first length.

2. The storage device of claim 1,
wherein the guide frame comprises a first member and a second member that are parallel in the first direction and face each other in the second direction, and
wherein the slot is formed in at least one of the first member and the second member.

3. The storage device of claim 2, wherein the slot penetrates through the first member.

4. The storage device of claim 2, wherein the slot does partially penetrates through the first member.

5. The storage device of claim 2, wherein a length of the slot is equal to or less than a length of the first member in the first direction.

6. The storage device of claim 2,
wherein a first groove into which a side of the substrate is configured to be inserted is formed in the first member, and
wherein a second groove into which the other side of the substrate is configured to be inserted is formed in the second member.

7. The storage device of claim 1,
wherein the tray comprises a first pin and a second pin extending in the first direction,
wherein the tray comprises a third pin and a fourth pin extending in the second direction, and
wherein, when the loss of power occurs, the third pin is configured to move along the slot by the first length.

8. The storage device of claim 7, wherein the first pin, the second pin, the third pin, and the fourth pin are coupled to the guide frame.

9. The storage device of claim 1, wherein the electronic element comprises a volatile memory and a nonvolatile memory.

10. The storage device of claim 1, wherein the connector is disposed at an end of the substrate and comprises a plurality of connection terminals connected to the host device.

11. The storage device of claim 1, further comprising a latch unit connected to the host device,
wherein, when the latch unit and the host device are separated, the tray is configured to move along the slot by the first length.

12. An electronic device comprising:
a storage device; and
a host device connected to the storage device,
wherein the host device comprises:
a power supply configured to supply main power to the storage device;
a baseboard management controller (BMC) circuit configured to provide a data flush command to the storage device when a loss of the main power occurs; and
a power loss protection (PLP) circuit configured to provide a detection signal to the BMC circuit by detecting the loss of the main power and supplying auxiliary power when the loss of the main power occurs, and
wherein the storage device comprises:
a substrate;
a volatile memory and a nonvolatile memory disposed on the substrate;
a connector disposed at an end of the substrate and configured to be connected to the host device; and
a tray on which the substrate is mounted and a guide frame having a slot formed to extend to a first length,
wherein, when the loss of the main power occurs, the tray is configured to move along the slot by the first length.

13. The electronic device of claim 12, wherein, when the loss of the main power occurs, the BMC circuit is configured to flush data of the volatile memory to the nonvolatile memory.

14. The electronic device of claim 12,
wherein the substrate extends in a first direction and a second direction that intersect each other,
wherein the tray comprises a first pin and a second pin extending in the first direction, wherein the tray comprises a third pin and a fourth pin extending in the second direction, and
wherein, when the loss of the main power occurs, the third pin is configured to be accommodated in the slot and move by the first length.

15. The electronic device of claim 12,
wherein the PLP circuit comprises:
a first energy circuit comprising a first capacitor and a first controller that supply first auxiliary power to the storage device; and
a second energy circuit comprising a second capacitor and a second controller that supply second auxiliary power to the storage device,
wherein the first controller is configured to monitor a power status of the first capacitor and control the first capacitor to supply the first auxiliary power to the storage device, and
wherein the second controller is configured to monitor the power status of the second capacitor and control the second capacitor to supply the second auxiliary power to the storage device.

## Amended claims

### Amended claims in accordance with Rule 137(2) EPC.

1. A storage device comprising:
a substrate (100) comprising a first surface (100_1) that extends in a first direction (X) and a second direction (Y) that intersect each other;
an electronic element (CHP) disposed on the first surface (100_1) of the substrate (100);
a connector (300) attached to or integrated with the substrate (100) and connectable to a host device (1000);a tray (400) on which the substrate (100) is mounted; and
a guide frame (500) disposed in the tray (400), the guide frame (500) being configured to support the substrate (100) and having a slot (510S) extending along the first direction (X) to a first length (D1),
wherein the tray (400) comprises a first pin (413P) extending in the second direction (Y) and accommodated in the slot (510S) so that the tray (400) is movable in the first direction (X) with respect to the guide frame (500) up to a distance that equals the length (D1) of the slot (510S).

2. The storage device of claim 1,
wherein the guide frame (500) comprises a first member (510) and a second member (520) that are parallel in the first direction (X) and face each other in the second direction (Y), and
wherein the slot (510S) is formed in at least one of the first member (510) and the second member (520).

3. The storage device of claim 2, wherein the slot (510S) penetrates through the first member (510).

4. The storage device of claim 2, wherein the slot (510S) partially penetrates through the first member (510).

5. The storage device of claim 2, wherein a length (D1) of the slot (510S) is equal to or less than a length of the first member (510) in the first direction (X).

6. The storage device of claim 2,
wherein a first groove (510A) into which a side of the substrate (100) is configured to be inserted is formed in the first member (510), and
wherein a second groove (520A) into which the other side of the substrate (100) is configured to be inserted is formed in the second member (520).

7. The storage device of claim 1,
wherein the tray (400) further comprises a second pin (414P) extending in the second direction (Y), and a third pin (411P) and a fourth pin (412P) extending in the first direction (X).

8. The storage device of claim 7, wherein the first pin (413P), the second pin (414P), the third pin (411P), and the fourth pin (412P) are coupled to the guide frame (500).

9. The storage device of claim 1, wherein the electronic element (CHP) comprises a volatile memory and a nonvolatile memory (2200).

10. The storage device of claim 1, wherein the connector (300) is disposed at an end of the substrate (100) and comprises a plurality of connection terminals (EL) connectable to the host device (1000).

11. The storage device of claim 1, further comprising a latch unit (600) connectable to the host device (1000), wherein, when the latch unit (600) is connected to the host device (1000), the latch unit (600) is electrically connected to a pad disposed at one end of the host device (1000), and wherein, when the latch unit (600) is separated from the host device (1000), the latch unit (600) is electrically separated from the pad disposed at the one end of the host device (1000).

12. An electronic device comprising:
a storage device (2000) according to any one of the preceding claims; and
a host device (1000) connected to connector (300) of the storage device (2000),
wherein the host device (1000) comprises:
a power supply (1110) configured to supply main power (MPWR1) to the storage device (2000);
a baseboard management controller, BMC, circuit (1120) configured to provide a data flush command (FCMD) to the storage device (2000) when a loss of the main power (MPWR1) occurs; and
a power loss protection, PLP, circuit (1200) configured to provide a detection signal (DS) to the BMC circuit (1120) by detecting the loss of the main power (MPWR1) and supplying auxiliary power (APWR) when the loss of the main power (MPWR1) occurs.

13. The electronic device of claim 12, wherein the storage device (2000) is a storage device (2000) according to claim 9, and wherein, when the loss of the main power (MPWR1) occurs, the BMC circuit (1120) is configured to flush data of the volatile memory to the nonvolatile memory (2200).

14. The electronic device of claim 12,
wherein the PLP circuit (1200) comprises:
a first energy circuit (1210) comprising a first capacitor (1212) and a first controller (1211) that supply first auxiliary power (APWR) to the storage device (2000); and
a second energy circuit (1220) comprising a second capacitor (1222) and a second controller (1221) that supply second auxiliary power (APWR) to the storage device (2000),
wherein the first controller (1211) is configured to monitor a power status of the first capacitor (1212) and control the first capacitor (1212) to supply the first auxiliary power (APWR) to the storage device (2000), and
wherein the second controller (1221) is configured to monitor the power status of the second capacitor (1222) and control the second capacitor (1222) to supply the second auxiliary power (APWR) to the storage device (2000).
